# EUROPÄISCHE PATENTANMELDUNG

(11) **EP 4 105 359 A1**
(43) Veröffentlichungstag der Anmeldung: **21.12.2022**
(21) Anmeldenummer: 21180034.7
(22) Anmeldetag: 17.06.2021
(51) Int. Cl.: C25B 1/04, C23C 16/18, C23C 16/455, C25B 9/75, C25B 9/77, C25B 11/073, C25B 13/02

(54) **IONEN-AUSTAUSCH-MEMBRAN, VERFAHREN ZUM HERSTELLEN DER IONEN-AUSTAUSCH-MEMBRAN, ELEKTROLYSE-VORRICHTUNG MIT DER IONEN-AUSTAUSCH-MEMBRAN UND VERWENDUNG DER ELEKTROLYSE-VORRICHTUNG**

(71) Anmelder: Siemens Aktiengesellschaft, 80333 München (DE)
(72) Erfinder: Jensen, Jens Dahl, 14050 Berlin (DE); Krüger, Ursus, 14089 Berlin (DE); Winkler, Gabriele, 13587 Berlin (DE)

(57) **Zusammenfassung**

Die Erfindung betrifft eine Ionen-Austausch-Membran für eine Elektrolyse-Zelle mit einer anodenseitigen Membran-Oberfläche zur Begrenzung eines Anoden-Raums der Elektrolyse-Zelle, einer der anodenseitigen Membran-Oberfläche abgewandten kathodenseitigen Membran-Oberfläche zur Begrenzung eines Kathoden-Raums der Elektrolyse-Zelle und mindestens einer direkt auf mindestens einer der Membran-Oberflächen aufgebrachten Redox-Katalysator-Beschichtung mit Redox-Katalysator-Material angegeben. Dabei weist die Redox-Katalysator-Beschichtung eine Gasphasen-Abscheidung auf. Die Erfindung betrifft auch ein Verfahren zum Herstellen der Ionen-Austausch-Membran, wobei folgende Verfahrensschritte durchgeführt werden: a) Bereitstellen einer Ausgangs-Ionen-Austausch-Membran mit einer anodenseitigen Ausgangs-Membran-Oberfläche und einer der anodenseitigen Ausgangs-Membran-Oberfläche abgewandten kathodenseitigen Ausgangs-Membran-Oberfläche und b) Anordnen zumindest einer Redox-Katalysator-Beschichtung auf zumindest einer der Ausgangs-Membran-Oberflächen, wobei zum Anordnen der Redox-Katalysator-Beschichtung ein Gas-Phasen-Abscheiden eines Redox-Katalysator-Materials und/oder eines Ausgangs-Materials (Precursor-Material) des Redox-Katalysator-Materials durchgeführt werden. Die Ionen-Austausch-Membran wird für eine Elektrolyse-Vorrichtung mit Elektrolyse-Zelle zur Wasser-Elektrolyse eingesetzt.

## Beschreibung

Die Erfindung betrifft eine Ionen-Austausch-Membran und ein Verfahren zum Herstellen der Ionen-Austausch-Membran. Daneben betrifft die Erfindung eine Elektrolyse-Vorrichtung mit der Ionen-Austausch-Membran und eine Verwendung der Elektrolyse-Vorrichtung.

Für die Umwandlung und die Speicherung von Energien aus erneuerbaren Quellen wie Wind, Wasser und Sonne über längere Zeiträume werden unter anderem Wasser-Elektrolyseure in sogenannten Power-to-Gas-Anlagen eingesetzt. Ein Wasser-Elektrolyseur ist eine Elektrolyse-Vorrichtung. Der Wasser-Elektrolyseure nutzt den aus Wind, Sonne oder Wasserkraft gewonnenen Öko-Strom, um Wasser in Wasserstoff und Sauerstoff elektrochemisch mit Hilfe von Redox-Katalysatoren zu zerlegen. Wasserstoff ist ein Energieträger, der im Gegensatz zu fossilen Brennstoffen bei der Verbrennung keine schädlichen Kohlendioxid-Emissionen verursacht. Außerdem lässt sich der Wasserstoff in die bestehende Erdgas-Infrastruktur auf einfache Weise einspeisen.

Als Wasser-Elektrolyseure werden kommerziell die trockene Polymer-Elektrolyt-Membran-Elektrolyse (PEM-Elektrolyse) und die alkalische Elektrolyse genutzt. Allen Wasser-Elektrolyseuren gemein sind eine Wasserstoff-Entwicklungs-Reaktion (Hydrogen Evolution Reaction, HER) an einer Kathode des Wasser-Elektrolyseurs und eine Sauerstoff-Entwicklungs-Reaktion (Oxygen Evolution Reaction, OER) an einer Anode des Wasser-Elektrolyseurs.

Zur Gewinnung von reinem Wasserstoff an der Kathode werden die HER- und die OER-Rektion räumlich durch eine stromdurchlässige Wand voneinander getrennt. Anoden-Raum und Kathoden-Raum werden voneinander getrennt. Die Wand verhindert die Durchmischung, lässt aber einen Strom durch Ionenleitung hindurch.

Die Wand ist eine organische oder anorganische Ionen-Austausch-Membran. Beispielsweise ist die Ionen-Austausch-Membran eine Protonen-Austausch-Membran (Proton Exchange Membran, PEM) oder eine Anionen-Austausch-Membran (Anion Exchange Membran, AEM) bzw. ein Diaphragma. Bei der Protonen-Austausch-Membran können Protonen (H⁺ bzw. H₃O⁺) durch die Wand hindurch wandern. Bei der Anionen-Austausch-Membran können Anionen, beispielsweise Hydroxid-Ionen (OH⁻) durch die Wand gelangen.

Die PEM- Elektrolyse hat den Nachteil, dass hier zum Betreiben des Wasser-Elektrolyseurs mit vollentsalztem Wasser wegen der Empfindlichkeit der eingesetzten Redox-Katalysatoren vor Vergiftung gearbeitet werden muss. Vollentsalztes Wasser enthält H₃O⁺ - Ionen, die das Rohrsystem der PEM- Elektrolyse-Vorrichtung (z.B. PEM-Stack) stark angreifen. Dieses Rohrsystem bestehen aus Edelstahl, Aluminium oder Titan und wird durch die sauren Eigenschaften des vollentsalzten Wassers korrodiert. Dabei werden einzelne Metall-Ionen (z.B. Fe³⁺, Al³⁺ oder Ti²⁺ herausgelöst. Diese können die Ionen-Austausch-Membran schädigen. Beispielsweise ist die Ionen-Austausch-Membran eine Nafion^{®}-Membran. Die genannten Metall-Ionen können sich z.B. an deprotonierten Sulfonsäure-Gruppen festsetzen, die an den Seitenketten des perfluorierten Polymerrückgrats des Nafions^{®} gebunden sind. Damit stehen diese Sulfonsäure-Gruppen einer Protonen-Wanderung von der Anode zur Kathode nicht mehr zur Verfügung. Die Protonen-Leitfähigkeit und damit die Stromdichte des PEM Stacks sinken.

Aufgabe der vorliegenden Erfindung ist es, aufzuzeigen, wie die Ionen-Austausch-Membran gestaltet werden kann, so dass das Problem der korrosiven Schädigung durch H₃O⁺-Ionen umgangen werden kann. Dabei soll die Stromdichte der Elektrolyse-Vorrichtung erhalten bleiben. Gleichzeitig sollen Material-Kosten eingespart werden.

Zur Lösung der Aufgabe wird eine Ionen-Austausch-Membran für eine Elektrolyse-Zelle mit einer anodenseitigen Membran-Oberfläche zur Begrenzung eines Anoden-Raums der Elektrolyse-Zelle, einer der anodenseitigen Membran-Oberfläche abgewandten kathodenseitigen Membran-Oberfläche zur Begrenzung eines Kathoden-Raums der Elektrolyse-Zelle und mindestens einer direkt auf mindestens einer der Membran-Oberflächen aufgebrachten Redox-Katalysator-Beschichtung mit Redox-Katalysator-Material angegeben. Dabei weist die Redox-Katalysator-Beschichtung eine Gasphasen-Abscheidung auf.

Zur Lösung der Aufgabe wird auch ein Verfahren zum Herstellen der Ionen-Austausch-Membran angegeben, wobei folgende Verfahrensschritte durchgeführt werden:
a) Bereitstellen einer Ausgangs-Ionen-Austausch-Membran mit einer anodenseitigen Ausgangs-Membran-Oberfläche und einer der anodenseitigen Ausgangs-Membran-Oberfläche abgewandten kathodenseitigen Ausgangs-Membran-Oberfläche und
b) Anordnen zumindest einer Redox-Katalysator-Beschichtung auf zumindest einer der Ausgangs-Membran-Oberflächen, wobei zum Anordnen der Redox-Katalysator-Beschichtung ein Gas-Phasen-Abscheiden eines Redox-Katalysator-Materials und/oder eines Ausgangs-Materials (Precursor-Material) des Redox-Katalysator-Materials durchgeführt werden.

Das Ausgangs-Material des Redox-Katalysator-Materials ist beispielsweise eine Übergangs-Metall-Komplex-Verbindung. Die Übergangsmetalle sind beispielsweis Übergangs-Metalle der 8. Neben-Gruppe des Periodensystems der Elemente (z.B. Eisen (Fe), Cobalt (Co) und Nickel (Ni)). Mögliche Übergangs-Metall-Komplex-Verbindungen sind in den Tabellen 1 (Cobalt-Verbindungen), 2 (Nickel-Verbindungen) und 3 (Eisen-Verbindungen) angegeben. Die Tabellen sind nicht abschließend.

**Tabelle 1: Cobalt-Verbindungen**

| Verbindung | Fig |
|---|---|
| Bis(N-t-butyl-N'-ethylpropanimidamidato)cobalt (II) | 8A |
| Bis(N,N'-di-i-propylacetamidinato)cobalt (II) | 8B |
| Bis(1,4-di-t-butyl-1,3-diazabutadienyl)cobalt(II) | 8C |
| Bis(cyclopentadienyl)cobalt(II) | 8D |
| Cobalt(tricarbonyl)nitrosyl | 8E |
| Cobalt(cyclopentadienyl)(dicarbonyl) | 8F |
| (3,3-Dimethyl-1-butyne)dicobalt hexacarbonyl, CCTBA | 8G |
| Tris(2,2,6,6-tetramethyl-3,5-heptanedionato)cobalt(III), [Co(TMHD)₃] | 8H |

**Tabelle 2: Nickel-Verbindungen**

| Verbindung | Fig |
|---|---|
| Bis[1-(N,N-dimethylamino)-2-propanolato]nickel (II) | 9A |
| (Allyl)(cyclopentadienyl)nickel (II) | 9B |
| (Acetonitril) (dichloro)nickel(II) | 9C |
| Bis(1,4-di-t-butyl-1,3-diazabutadienyl)nickel(II), Ni(DAD)2 | 9D |
| Bis(cyclopentadienyl)nickel, Nickelocen | 9E |
| Bis(N,N'-di-t-butylacetamidinato) nickel(II) | 9F |
| Bis(ethylcyclopentadienyl)nickel | 9G |
| Bis(pentamethylcyclopentadienyl) nickel, (Decamethylnickelocen) | 9H |
| Bis(i-propylcyclopentadienyl) nickel | 9I |
| Bis(2,2,6,6-tetramethyl-3,5-heptanedionato)nickel(II), [Ni(TMHD)₂] | 9J |
| Nickel(II)(acetylacetonat), anhydrid | 9K |
| Nickel(II)(acetylacetonat)(hydrat) | 9L |

**Tabelle 3: Eisen-Verbindungen**

| Verbindung | Fig |
|---|---|
| Tris(2,6-dimethyl-3,5-heptanedionato)Eisen(III), Fe(dibm) 3 | 10A |
| Bis(cyclopentadienyl)Eisen, (Ferrocen) | 10B |
| Bis(N,N'-di-t-butylacetamidinato)Eisen (II) | 10C |
| Bis(ethylcyclopentadienyl) Eisen | 10D |
| Bis(1,1,1,5,5,5-hexafluoroacetylacetonato)(N,N,N',N'-tetramethylethylenediamine)Eisen(II) | 10E |
| Bis(pentamethylcyclopentadienyl)Eisen | 10F |
| Bis(i-propylcyclopentadienyl)Eisen | 10G |
| n-Butylferrocen | 10H |
| t-Butylferrocen | 10I |
| (Cyclooctatetraen)(tricarbonyl)Eisen | 10J |
| Ethylferrocen | 10K |
| (Trifluoroacetylacetonat)Eisen(III) | 10L |
| Tris(2,2,6,6-tetramethyl-3,5-heptanedionato)Eisen(III), [Fe(TMHD)₃] | 10M |

Die Redox-Katalysator-Beschichtung wird mittels Gasphasen-Abscheiden aufgebracht. Das Ergebnis ist die (dünne) Gasphasen-Abscheidung. Als Gas-Phasen-Abscheiden werden insbesondere ein physikalisches Gasphasen-Abscheiden (PVD) und/oder ein chemisches Gasphasen-Abscheiden (CVD) durchgeführt. Es kann ein physikalisch-chemisches Abscheiden erfolgen, beispielsweise als Atomlagen-Abscheiden (atomic layer depostion, ALD). Das Gasphasen-Abscheiden wird beispielsweise in Gegenwart von Vakuum oder in Gegenwart einer reaktiven Komponente (z.B. in Gegenwart eines Plasmas) durchgeführt.

Zum Gasphasen-Abscheiden kann die Ausgangs-Ionen-Austausch-Membran, die betreffende Ausgangs-Membran-Oberfläche der Ausgangs-Ionen-Austausche-Membran und/oder die aufgetragene Beschichtung aus dem Redox-Katalysator-Material vor, während oder nach dem Gasphasen-Abscheiden chemisch und/oder physikalisch (z.B. thermisch) behandelt werden. Es wird eine Prozessierung durchgeführt.

Gemäß einer besonderen Ausgestaltung wird zum Verfahren eine Rolle-zu-Rolle-Vorrichtung verwendet. Das Verfahren ist als Rolle-zu-Rolle-Verfahren (roll-to-roll, R2R) ausgebildet. Hierfür wird die sich auf einer Transport-Rolle befindliche unbeschichtete Ausgangs-Ionen-Austausch-Membran abgerollt, bearbeitet und schließlich als fertige, mit der Redox-Katalysator-Beschichtung beschichtete Ionen-Austausch-Membran auf eine weitere Transport-Rolle aufgerollt. Auf diese Weise kann die Ionen-Austausch-Membran automatisiert und kostengünstig hergestellt werden.

Ein weiterer Aspekt der Erfindung bezieht sich auf eine Elektrolyse-Vorrichtung mit zumindest einer Elektrolyse-Zelle mit der Ionen-Austausch-Membran. Die Elektrolyse-Zelle weist folgenden Schichtaufbau auf:
- Anode,
- Ionen-Austausch-Membran,
- Kathode.

Darüber hinaus wird eine Verwendung der Elektrolyse-Zelle zum Herstellen von elementarem Wasserstoff aus Wasser angegeben. Die Ionen-Austausch-Membran wird in einem Wasser-Elektrolyseur eingesetzt.

Besondere Ausgestaltungen der Erfindung sind den abhängigen Ansprüchen zu entnehmen.

Die Ionen-Austausch-Membran weist zumindest einen Abschnitt auf, der für Ionen durchlässig ist. Diese Ionen sind vorzugweise Protonen (H⁺, genauer H₃O⁺-Ionen) oder Hydroxid-Ionen (OH⁻-Ionen).

Vorzugsweise wird nicht reines Wasser der Elektrolyse unterzogen, sondern eine hydroxid-haltige Lösung. Zum Beispiel kann mit der Erfindung eine ein-molare Kaliumhydroxid-Lösung der Elektrolyse unterzogen werden. Damit wird das Angreifen des Rohrsystems der Elektrolyse-Vorrichtung durch H₃O⁺-Ionen eingeschränkt. Ein Auflösen der Metalle des Rohrsystems der Elektrolyse-Vorrichtung wird unterbunden. Es kommt nicht zur Schädigung des Rohrsystems der Elektrolyse-Vorrichtung durch den korrosiven Angriff von H₃O⁺-Ionen.

Die Ionen-Austausch-Membran bzw. der für Ionen durchlässige Abschnitt der Ionen-Austausch-Membran weist Ionen-Austausch-Membran-Material auf, das vorzugsweise aus der Gruppe organisches oder anorganisches Ionen-Austausch-Membran-Material ausgewählt ist. Das organische Ionen-Austausch-Membran-Material ist beispielsweise ein organisches Polymer, aus dem die eingangs genannte Nafion^{®}-Membran aufgebaut ist. Das anorganische Ionen-Austausch-Membran-Material ist beispielsweise eine Keramik. Denkbar ist auch eine Mischung aus anorganischem und organischem Ionen-Austausch-Membran-Material.

Bei einem Ionen-Austausch-Membran-Material in Form eines organischen Polymers ist die Durchlässigkeit für Ionen mittels spezieller funktioneller Gruppen ermöglicht, die sich in den Seitenketten des polymeren Rückgrats des organischen Polymers befinden. So weist beispielsweise eine Ionen-Austausch-Membran für die Durchlässigkeit für Protonen Sulfonsäure- Gruppen auf. Alkyl-substituierte quartäre (quarternäre) Armine ermöglichen beispielsweise die Wanderung von Hydroxid-Ionen durch die Ionen-Austausch-Membran.

Bei der alkalischen Elektrolyse kann beispielsweise auch eine Ionen-Austausch-Membran in Form eines entsprechenden Diaphragmas verwendet werden. Das dafür verwendete Diaphragma weist beispielsweise eine Zirfon^{®}-Folie auf, die ein poröses Komposit-Material aufweist, das aus einem mit ZirkoniumDioxid (ZrO₂) beschichtetem Poly-Sulfon- Gewebe besteht. Der Transport von Hydroxid-Ionen wird durch eine feine Porenstruktur gewährleistet, die mit Elektrolyt-Lösung ausgefüllt wird.

Die Gasphasen-Abscheidung kann sehr dünn aufgebracht werden. Dadurch kann Redox-Katalysator-Material eingespart werden, obwohl eine chemisch aktive Oberfläche der Redox-Katalysator-Beschichtung im Vergleich zu anderen Auftrage-Verfahren (z.B. nass-chemisches Auftragen der Redox-Katalysator-Beschichtung) annähernd gleichbleibt.

Vorzugsweise weist die Redox-Katalysator-Beschichtung mit der Gasphasen-Abscheidung eine durchschnittliche Schichtdicke auf, die aus dem Bereich von 1 nm bis 100 nm ausgewählt ist. Gemäß einer besonderen Ausgestaltung ist die durchschnittliche Schichtdicke aus dem Bereich von 10 nm bis 90 nm und insbesondere aus dem Bereich von 20 nm bis 80 nm ausgewählt.

Die Redox-Katalysator-Beschichtung kann unstrukturiert auf der Ionen-Austausch-Membran aufgebracht sein. Vorzugsweise ist die Redox-Katalysator-Beschichtung aber strukturiert aufgebracht. In einer besonderen Ausgestaltung weist die Redox-Katalysator-Beschichtung mit der Gasphasen-Beschichtung daher eine Beschichtungs-Strukturierung auf. Die Beschichtungs-Strukturierung weist vorzugsweise eine Gitter-Struktur auf. Durch die Beschichtungs-Strukturierung kann eine aktive Oberfläche der Redox-Katalysator-Beschichtung im Vergleich zu einer unstrukturierten Redox-Katalysator-Beschichtung vergrößert werden. Gleichzeitig wird auch hier Redox-Katalysator-Material gespart.

Im Hinblick auf eine Effizienz der Elektrolyse-Vorrichtung erweist es sich als vorteilhaft, mehrere Elektrolyse-Zellen elektrisch in Reihe zu schalten. Gemäß einer besonderen Ausgestaltung sind zumindest zwei Elektrolyse-Zellen übereinandergestapelt und über mindestens eine bipolare Platte elektrisch und mechanisch miteinander verbunden. Eine solche Anordnung ist besonders platzsparend.

Zusammenfassend sind mit der Erfindung folgende Vorteile verbunden:
- Mit der Erfindung kann Redox-Katalysator-Material zur Herstellung der Redox-Katalysator-Beschichtung eingespart werden. Beispielsweise wird Iridium als Redox-Katalysator-Material eingesetzt. Abschätzungen ergeben, dass mit der Erfindung ungefähr 99,3% des Iridiums gegenüber anderen Verfahren zum Aufbringen der Redox-Katalysator-Beschichtung auf der Ausgangs-Ionen-Austausch-Membran (z.B. Tintenspritz-Technik oder Decal-Verfahren) eingespart und damit Kosten eingespart werden können. Zudem wird eine Abhängigkeit von limitierenden Faktoren hinsichtlich der Redox-Katalysator-Materialien entschärft.
- Mit der Erfindung ist eine direkte Beschichtung der Ausgangs-Ionen-Austausch-Membran mit Redox-Katalysatoren möglich.
- Durch das Gasphasen-Abscheiden kann die für die Redox-Katalysator-Beschichtung benötigte Menge an Katalysator-Material verringert werden.
- Das Gasphasen-Abscheiden ermöglicht eine Vergrößerung der katalytisch aktiven Oberfläche der Redox-Katalysator-Beschichtung.
- Die durchschnittliche Schichtdicke der Redox-Katalysator-Beschichtung liegt im atomaren Bereich bzw. im Nanometer-Bereich. Dies ermöglicht Tunnel-Effekte und Hopping-Mechanismen für die Elektronenleitung. Die Elektronen können schneller von einem lokalisierten Zustand in einem benachbarten springen, da die Abstände zwischen den Schichten klein sind.
- Mit dem Gasphasen-Abscheiden sind reine Redox-Katalysator-Beschichtungen zugänglich. Die Redox-Katalysator-Beschichtungen weisen keine Verunreinigungen aufgrund z.B. nass-chemischer Abscheideverfahren auf. Solche Verunreinigungen wären beispielsweise anorganische Anionen wie Chloride, Reduktionsmittel, Tenside oder AusgangsVerbindungen des Redox-Katalysator-Materials (z.B. Iridium-Chlorid oder Platin-Chlorid).
- Mit der Erfindung werden größere Partikel-Anhäufungen und Agglomerate vermieden, da die Redox-Katalysatoren als zusammenhängende Schicht auf einer Ausgangs-Ionen-Austausch-Membran abgeschieden werden und nicht z.B. über eine Tinte als Partikel in Form eines Pulvers.
- Ein Ablösen von einzelnen Redox-Katalysator-Partikeln von der Ionen-Austausch-Membran ist nicht möglich, da der Redox-Katalysator auf der Ionen-Austausch-Membran als zusammenhängende Schicht abgeschieden wird (im Gegensatz z.B. zu der Tintenspritz-Technik).
- Bei dem Gasphasen-Abscheiden kommen keine polymeren Bindemittel zum Einsatz. Es kommt damit zu keinen Vergiftungserscheinungen am Redox-Katalysator.
- Mit der Erfindung kann die Redox-Katalysator-Beschichtung strukturiert aufgebracht werden. Das führt dazu, dass beispielsweise die bei der Wasserspaltung entstehenden Wasserstoff- Ionen an den nicht- beschichteten Stellen der Oberfläche der Ionen-Austausch-Membran leicht durch die Ionen-Austausch-Membran von der Anodenseite auf die Kathodenseite transportiert werden können.
- Mit der Erfindung werden die Redox-Katalysatoren durch Polymere nicht vergiftet. Beispielsweise können die Redox-Katalysatoren bei der Tintenspritz-Technik (Iridium-Dioxid-Partikel in einer Nafion^{®}- Lösung dispergiert) durch das Bindemittel vergiftet werden. Nafion^{®} als Bindemittel besteht im Wesentlichen aus einem Fluor- Kohlenstoff-Gerüst mit CF₂-Seitenketten. Die Fluor-Atome sind nach außen elektronegativ durch freie Elektronenpaare geladen. Diese freien Elektronenpaare können an die positiven Zentren (Elektronenlücken) des Redox-Katalysators andocken. Damit steht der Redox-Katalysator für weitere chemische Umsetzungen und Bildung von Zwischenstufen nicht mehr zur Verfügung. Der Redox-Katalysator ist vergiftet und die Katalysatoraktivität wird eingeschränkt. Dies wird mit der Erfindung vermieden.
- Werden Iridium(Ir)- oder Platin(Pt)- basierte Aktiv-Komponenten aus der Gasphase über entsprechende AusgangsVerbindungen auf die Ausgangs-Ionen-Austausuch-Membran abgeschieden, können größere Partikel-Anhäufungen und Agglomerate vermieden werden. Damit sind die Redox-Katalysatoren sowohl auf der Anoden-Seite als auf der Kathoden-Seite einer Elektrolyse-Zelle sehr gut verteilt. Durch eine gute Verteilung wird die Anzahl der aktiven Zentren im Redox-Katalysator deutlich erhöht gegenüber einer Partikel-Anhäufung. Beispielsweis werden als Redox-Katalysator-Materialien Iridium und Platin eingesetzt. Eine Massen-Aktivität an Iridium und Platin wird gesteigert, da Iridium und Platin optimaler eingesetzt werden. Damit kann Iridium und Platin eingespart werden
- Mit der Erfindung sind sehr dünne und homogene Redox-Katalysator Beschichtungen mit gewünschter Stöchiometrie zugänglich.
- Im Gegensatz zur Tinten-Spritz-Technik werden die Redox-Katalysatoren als glatte Schichten abgeschieden, so dass Wasserstoff- oder Sauerstoffblasen an den glatten Flächen leicht abperlen können. Bei der Tintenspritztechnik liegen die Partikel häufig auch als Agglomerate vor. Diese Agglomerate zeigen Ecken und hervorstehende Kanten und bilden eine raue Partikeloberfläche. An diesen Flächen bleiben die Wasserstoff- und Sauerstoffblasen besonders gut haften und bei herrschenden Spannungen von 2 bis 3 Volt werden an den Anhaftungsstellen die Redox-Katalysatoren erodiert. Das bedeutet Verbrauch an teurem Redox-Katalysator-Material und Einschränkung der Katalysator-Aktivität. Mit der Erfindung tritt dieses Problem nicht auf. Durch das Abscheiden von Redox-Katalysator-Beschichtungen mit glatter Oberfläche word auch die elektrochemische Stabilität der Redox-Katalysatoren erhöht. Es findet keine bis sehr wenig Erosion durch die glatten Redox-Katalysatorschichten statt. Dadurch wird die Lebensdauer der Redox-Katalysatoren verlängert.
- Durch das Gasphasenabscheiden können die elektrochemisch aktiven Materialien nahtlos aneinandergefügt werden, so dass kaum ein Innenwiderstand zwischen den Materialien herrscht und der Ladungstransport ohne Hindernisse erfolgen kann.
- Beim Gasphasen-Abscheiden in Form des ALD- Verfahrens begrenzen sich die Oberflächenreaktionen durch die Art der Prozessführung selbst, so dass die aktiven Materialien in Schichtdicke und Zusammensetzung kalkulierbar und reproduzierbar abgeschieden werden.
- Mit der Erfindung ist ein industrieller Einsatz der Elektrolyse-Technologie möglich. Z.B. werden die mit der Herstellung der Ionen-Austausch-Membran verbundenen Kosten reduziert bei gleichzeitiger Erhöhung einer Elektrolyse-Leistung der Elektrolyse-Vorrichtung. Zudem ist eine für die Industrialisierung notwendige Skalierbarkeit (z.B. durch genaues Einstellen einer katalytisch aktiven Oberfläche der Redox-Katalysator-Beschichtung) gegeben. Elektrolyse-Leistungen im Mega- und Gigawatt-Bereich sind möglich.

Anhand mehrerer Ausführungsbeispiel und der dazugehörigen Figuren wird die Erfindung näher beschrieben. Die Figuren sind schematisch und stellen keine maßstabsgetreuen Abbildungen dar.

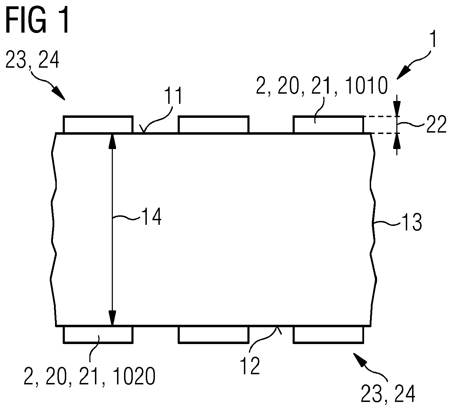

Figur 1 zeigt einen Ausschnitt einer Ionen-Austausch-Membran Querschnitt.

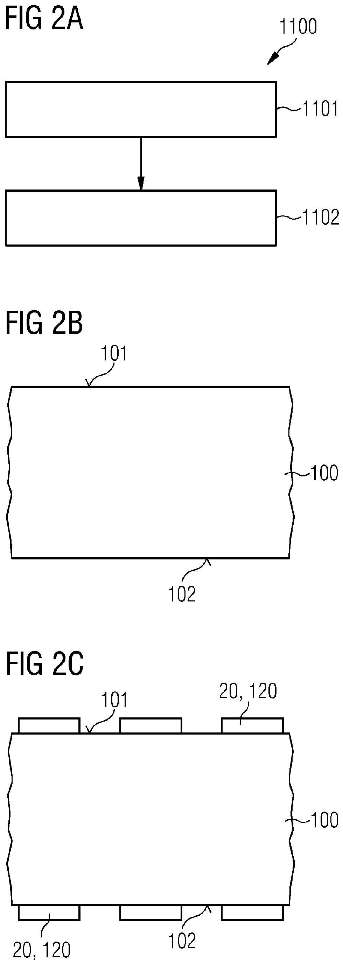

Figur 2A zeigt ein Verfahren zum Herstellen der Ionen-Austausch-Membran.
Figur 2B zeigt einen Ausschnitt einer Ausgangs-Ionen-Austausch-Membran für das Verfahren zum Herstellen der Ionen-Austausch-Membran im Querschnitt.
Figur 2C zeigt auf der Ausgangs-Ionen-Austausch-Membran (siehe Figur 2B) aufgebrachtes Redox-Katalysator-Material bzw. Ausgangs-Material (Precursor-Material) des Redox-Katalysator-Materials.
Figur 3 zeigt einen Ausschnitt einer Elektrolyse-Zelle im Querschnitt.
Figuren 4 und 5 zeigen jeweils ein Verfahren zum Herstellen der Ionen-Austausch-Membran.
Figur 6 zeigt einen Vakuum-Reaktor zur Abscheidung von Redox-Katalysator-Material bzw. von Ausgangs-Material des Redox-Katalysator-Materials auf der Ausgangs-Ionen-Austausch-Membran.
Figur 7 zeigt mögliche Taktzeiten eines Abscheidungs-Zykluses für die Abscheidung von Redox-Katalysator-Material bzw. Ausgangs-Material des Redox-Katalysator-Materials.

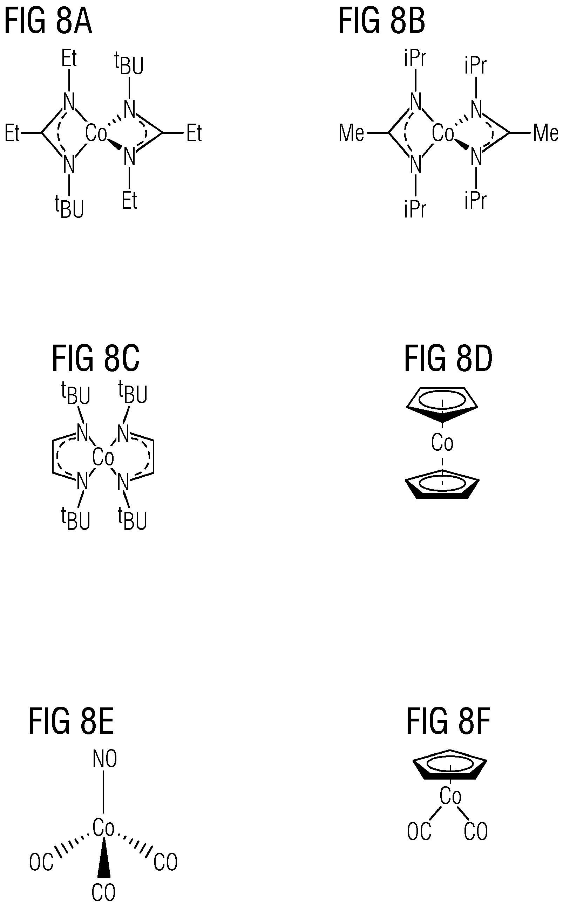

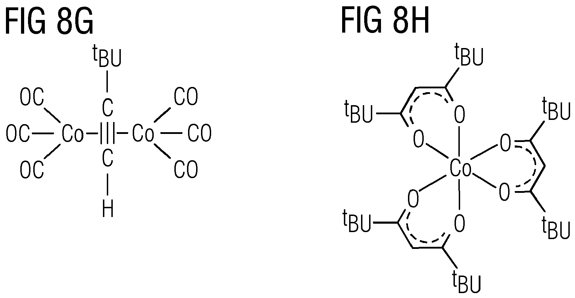

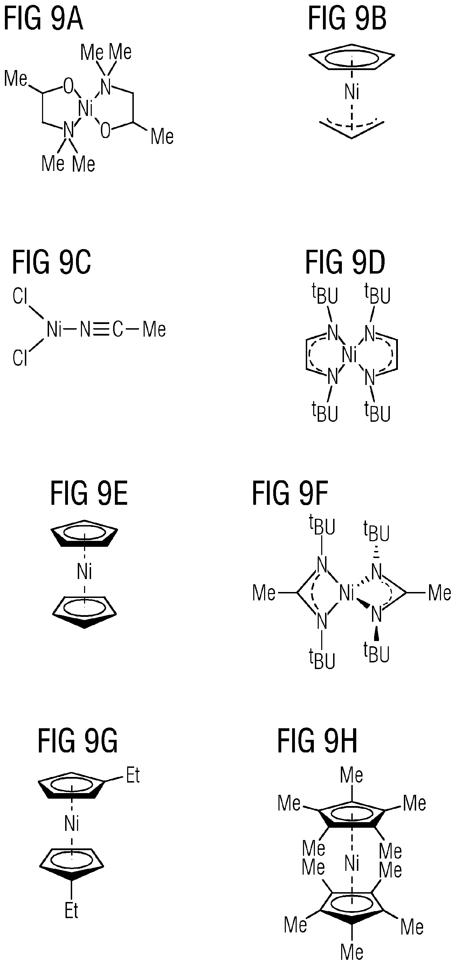

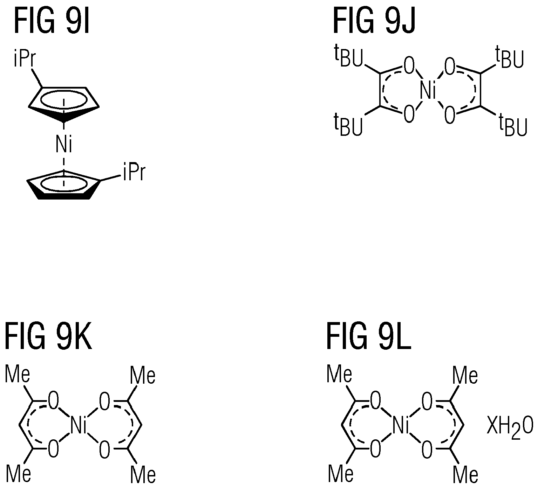

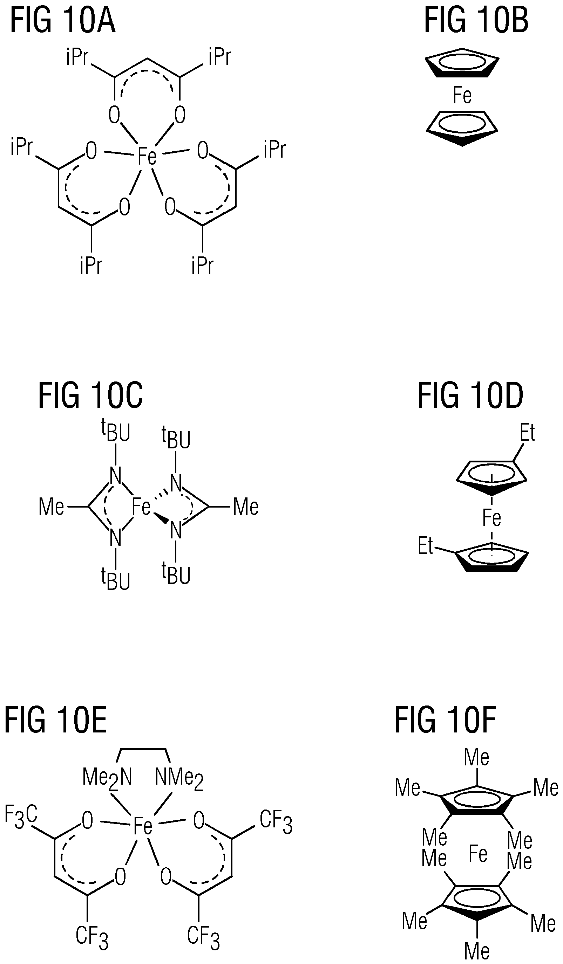

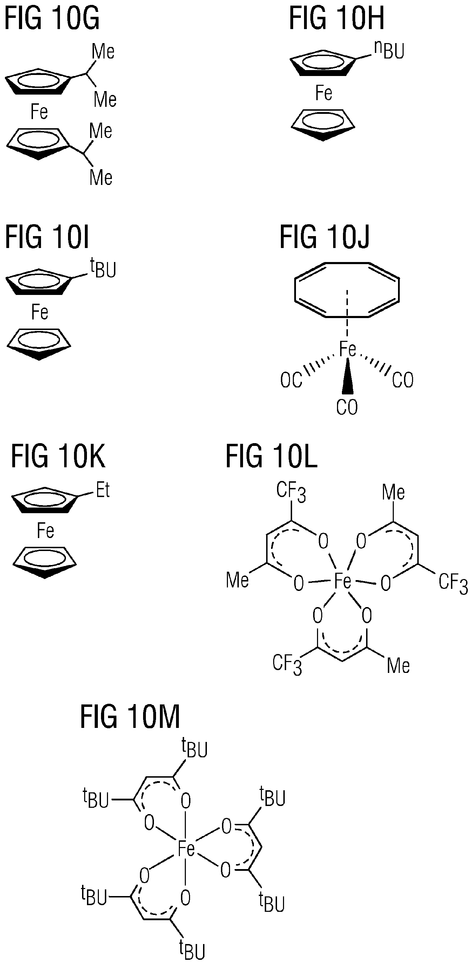

Figuren 8A bis 8H, 9A bis 9L und 10A bis 10M zeigen die Struktur-Formeln möglicher Metall-Precursor-Materialien zum Herstellen eines Redox-Katalysator-Materials.

Es wird eine Ionen-Austausch-Membran 1 für eine Elektrolyse-Zelle 1000 angegeben. Die Ionen-Austausch-Membran 1 ist ausgestattet mit einer anodenseitigen Membran-Oberfläche 11 zur Begrenzung eines Anoden-Raums 1011 der Elektrolyse-Zelle 1000 und einer der anodenseitigen Membran-Oberfläche 11 abgewandten kathodenseitigen Membran-Oberfläche 12 zur Begrenzung eines Kathoden-Raums 1021 der Elektrolyse-Zelle 1000.

Auf der anodenseitigen Membran-Oberflächen 11 und auf der kathodenseitigen Membran-Oberfläche 12 ist jeweils eine Redox-Katalysator-Beschichtung 2 aus Redox-Katalysator-Material 20 aufgebracht. Die auf der anodenseitigen Membran-Oberfläche 11 aufgebrachte Redox-Katalysator-Beschichtung 20 soll als Anode 1010 einer Elektrolyse-Zelle zur Bildung von elementarem Sauerstoff aus Wasser dienen (OER-Katalysator).

Die auf der kathodenseitigen Membran-Oberfläche 12 aufgebrachte Redox-Katalysator-Beschichtung 20 soll als Kathode 1021 einer Elektrolyse-Zelle 1000 zur Bildung von elementarem Wasserstoff aus Wasser fungieren (HER-Katalysator).

Kern der Ionen-Austausch-Membran 1 bildet eine Polymer-Membran (Polymer-Folie) mit organischem Ionen-Austausch-Membran-Material 13. Die Ionen-Austausch-Membran 1 ist eine Anion Exchange Membran (AEM), beispielweise des Typs A201 oder A901 der Firma Tokuyama. Eine Schicht-Dicke 14 der AEM-Folie beträgt 13 bis 30 µm.

Gemäß einer alternativen Ausführungsform ist die Ionen-Austausch-Membran 1 eine Zirfon^{®}-Folie. Die Zirfon^{®}-Folie weist anorganisches Ionen-Austausch-Membran-Material 13 auf. Eine Schichtdicke 14 der Zirfon^{®}-Folie beträgt 500 µm.

Die beiden Redox-Katalysator-Beschichtungen 20 sind jeweils Gasphasen-Abscheidungen 21. Die durchschnittlichen Schichtdicken 22 der Redox-Katalysator-Beschichtungen 20 betragen 10 nm.

Die Redox-Katalysator-Beschichtungen 2 sind strukturiert. Sie weisen als Beschichtungs-Strukturierung 23 jeweils eine Gitter-Struktur 24 auf.

Zur Herstellung der Ionen-Austausch-Membran 1 wird ein Verfahren 1000 mit folgenden Verfahrensschritten durchgeführt:
a) Bereitstellen (1101) einer Ausgangs-Ionen-Austausch-Membran (100) mit einer anodenseitigen Ausgangs-Membran-Oberfläche (101) und einer der anodenseitigen Ausgangs-Membran-Oberfläche (101) abgewandten kathodenseitigen Ausgangs-Membran-Oberfläche (102) und
b) Anordnen (1102) zumindest einer Redox-Katalysator-Beschichtung (2) auf zumindest einer der Ausgangs-Membran-Oberflächen (101, 102), wobei zum Anordnen der Redox-Katalysator-Beschichtung (2) ein Gas-Phasen-Abscheiden (1102) eines Redox-Katalysator-Materials (20) und/oder eines Ausgangs-Materials (120) des Redox-Katalysator-Materials (20) durchgeführt werden.

Als Gas-Phasen-Abscheiden wird ein chemisches Gasphasen-Abscheiden (CVD) durchgeführt, genauer ein atomic layer deposition (ALD)-Verfahren.

Gemäß der Ausführungsbeispiele können durch die Ionen-Austausch-Membran OH⁻-Ionen wandern, so dass die Elektrolyse-Zelle als alkalische Elektrolyse-Zelle betrieben werden kann. Dazu ist zunächst eine andere Membran-Elektroden-Einheit als die einer PEM-Elektrolyse-Zelle erforderlich. Um diese andere Membran-Elektroden-Einheit so dünn wie möglich zu halten, werden die Redox-Katalysatoren auf die jeweiligen Trennwände, die für die alkalische Elektrolyse erforderlich sind, aus der Dampfphase über einen Metall-Precursor und anschließend mit Hilfe der Behandlung mit einem eine Schicht bildenden Gases im Vakuum strukturiert abgeschieden.

Ein strukturiertes Abscheiden des Redox-Katalysators direkt auf der anodenseitigen Ausgangs-Membran-Oberfläche 101 einer Ausgangs-Ionen-Austausch-Membran bzw. auf der kathodenseitigen Ausgangs-Membran-Oberfläche 102 einer Ausgangs-Ionen-Austausch Membran 100 wird im Folgenden erläutert.

### 1. Maskierung der Ausgangs-Ionen-Austausch-Membran

Bevor der Redox-Katalysator direkt auf die Ausgangs-Membran-Oberflächen über chemisch physikalische Prozesse strukturiert aufgetragen werden kann, werden die Bereiche der Ausgangs-Ionen-Austausch-Membran geschützt, an denen kein Redox-Katalysator vorhanden sein soll.

Aus der Mikrosystem-Technologie ist bekannt, dass man Metalle auf Halbleitermaterialien, z. B. Silizium, durch einen geeigneten Fotolithografie-Prozess strukturieren kann. Solch ein Fotolithografie-Prozess wird auch zur direkten und strukturierten Redox-Katalysator-Beschichtung auf einer Ausgangs-Ionen-Austausch-Membran bzw. auf einem Diaphragma angewendet.

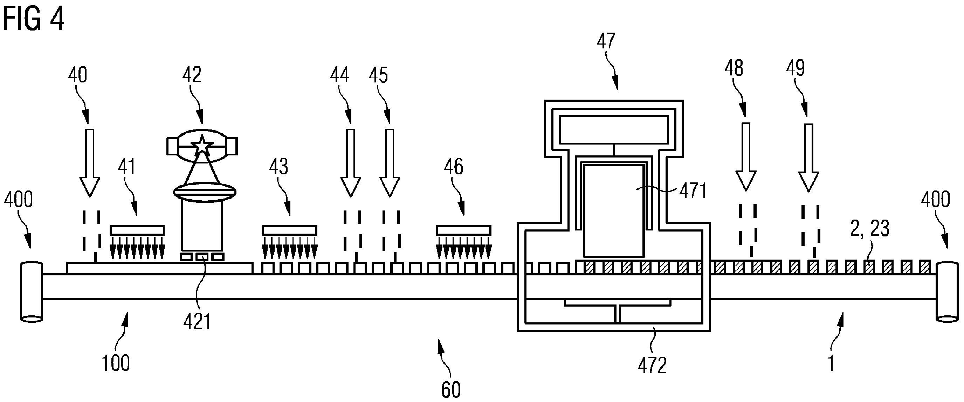

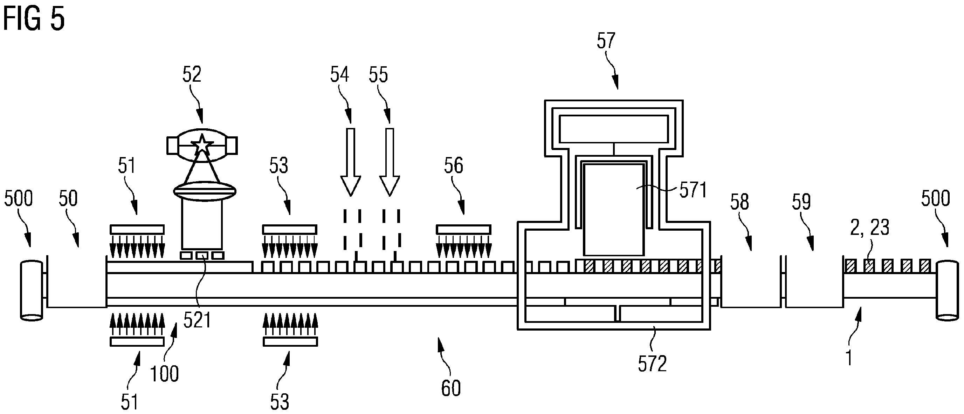

Figur 4 und 5 zeigen solche Strukturierungs- und Abscheidungsprozesse, die als Rolle-zu-Roll- Prinzip innerhalb einer Beschichtungs-Straße vollautomatisch ablaufen können. Es wird jeweils eine Rolle-zu-Rolle-Vorrichtung 60 mit Transport-Rollen 400 bzw. 500 verwendet.

Eine Ausgang-Ionen-Austausch-Membran, die in elektrochemischen Zellen angewandt wird, wird zunächst mit Sprühlack über eine Düse beschichtet (Sprüh-Lack-Beschichtungs-Einheit 40). Eine Schicht-Dicke des aufgesprühten Fotolacks beträgt 0,5 µ*m* bis 20 µm.

Gemäß dem Ausführungsbeispiel nach Figur 5 wird hier anstelle einer Sprüh-Lack-Beschichtungs-Einheit eine Tauch-Lack-Beschichtungs-Einheit 50 eingesetzt. Die resultierende Tauch-Lack-Beschichtung weist eine Schicht-Dicke von 2 µ*m* bis 10 µm auf.

Nach dem Auftragen der Foto-Lack-Schicht wird ein Ausheizschritt bei ca. 110°C mit Hilfe der Vor-Heiz-Einheit 41 durchgeführt. Dieser Schritt wird auch Pre-Bake oder Soft-Bake genannt. Bei diesem Teilprozessschritt wird das Lösungsmittel und ein Großteil des vorhandenen Wassers desorbiert. Es kommt zu einer Stabilisierung des Fotolacks.

Dann erfolgt die Belichtung des Fotolacks in der Belichtungs-Einheit 42 bzw. 52. Bei der Belichtung ist für die chemische Reaktion eine gewisse Menge an Restwasser in der Lackschicht wichtig, weil chemische Eigenschaften des Fotolacks in den belichteten Bereichen durch fotochemische Reaktionen verändert werden.

Vor der Belichtung wird die Position der Belichtungs-Maske 421 bzw. 521, die die Struktur beinhaltet, die auf den Fotolack übertragen werden soll, auf die Ionen-Austausch-Membran ausgerichtet. Dabei wird eine Maskenkante parallel zur entsprechenden Membrankante justiert. Die Ausrichtung der Strukturkanten auf der Belichtungs-Maske sind wiederum parallel zur Maskenkante. Aufwendige Justierstrukturen sind nicht erforderlich, da auf der Ionen-Austausch-Membran nur einfache rechtförmige Katalysatorstrukturen erzeugt werden. Damit reicht eine Justierung der Maskenkanten und der Membrankanten aus. Die Justierung kann automatisch erfolgen.

Die Belichtung erfolgt dann entweder über die Wahl bestimmter Wellenlängen aus dem Emissionsspektrum einer Quecksilberlampe (z.B. höhere Langenwellen als 300 nm bis 500 nm) oder durch monochromatisches Licht eines Excimer-Lasers (Excited Dimer-Laser, z.B. KrF- oder ArF Excimer-Laser).

Da die Struktur der Fotomaske mittels Schattenwurfs auf den lichtempfindlichen Fotolack übertragen wird, wird die Belichtungs-Maske in direktem bzw. nahezu direktem Kontakt mit dem Fotolack gebracht. Dabei hat die Belichtungs-Maske zum Fotolack einen geringen Abstand von 10 bis 50 µm (Proximity gap, Proximity-Belichtung), um eine Beschädigung von Fotolack und Belichtungs-Maske zu vermeiden. Ein Linsensystem sorgt für parallele Lichtstrahlen, wobei das geometrische Ausmaß der parallelen Lichtstrahlen genauso groß ist wie die zu belichtende Fläche der Ionen-Austausch-Membran.

Nach der Belichtung erfolgt ein erneuter Temperschritt (Post Exposure Bake) über die Nach-Heiz-Einrichtung 43 bzw. 53 zur Glättung von Fotolackstrukturprofilen oder zur Verstärkung der fotochemischen Reaktion.

Als nächster Teilschritt erfolgt die Entwicklung des Lacks über die Entwickler-Einheit 44 bzw. 54. Durch die Bestrahlung des Fotolacks mit monochromatischem Licht werden in den belichteten Bereichen die chemischen Eigenschaften des Fotolacks verändert. Je Art des Fotolacks wird der Fotolack löslich oder unlöslich gegenüber einer eingesetzten Entwicklerlösung. Löslichen Bereiche des Fotolacks werden nun über eine Düse durch den Entwickler von der Lackschicht auf der Membran- Oberfläche gelöst und entfernt. Anschließend wird mit deionisiertem Wasser gespült und mit einem warmen Luftstrom getrocknet. Dies erfolgt in der Nach-Entwicklungs-Einheit 45 bzw. 55.

Nach der Entwicklung und dem Reinigen der mit Fotolack vorstrukturierten Membran-Oberfläche wird nochmals ein Temperschritt (Hard Bake) bei 100 bis 180°C in der Vor-Plasma-Heizungs-Einheit 46 bzw. 56 durchgeführt. Hierbei wird der strukturierte Fotolack nochmals getrocknet bzw. der Fotolack wird dabei durch eine Vernetzungsreaktion stabilisiert. Dies ist vorteilhaft, da die Lackschicht bei dem folgenden Plasma- unterstützten Abscheidungsprozess eventuell durch das Plasma stark beansprucht wird.

Wird im Elektrolyseur zur Trennung der Reaktionsräume und zum Transport von geladenen Ionen für den Elektronenausgleich an den Elektroden ein Diaphragma, z.B. Zirfon^{®}-Folie gemäß alternativem Ausführungsbeispiel, verwendet, dann wird anstelle des Sprühlacks ein Tauchlack verwendet, wie in Figur 5 dargestellt ist.

Das ZrO₂ der Zirfon^{®}-Folie ist stark hydrophil und bildet eine feine Poren-Struktur aus. Im Elektrolyseur füllt die Elektrolyt-Lösung (z.B. 30 %- ige Kaliumhydroxid-Lösung) diese Poren aus und gewährleistet somit den Transport von Hydroxid-Ionen. Aufgrund einer Porengröße von 0,15 +/ - 0,05 µm ist bei der direkten Beschichtung der Zirfon^{®}-Folie über ein physikalisch- chemisches Abscheide-Verfahren zum Schutz der Rückseite eine Tauch-Lackierung (Figur 5) sinnvoll.

Vom Material des Tauch-Lacks hängt die Art der Belichtung ab. Z.B. wird zur Belichtung eine Quecksilberlampe verwendet, wenn eine UV- Empfindlichkeit des Tauch-Lacks bei 310 nm bis 440 nm liegt. Zur Erzeugung von monochromatischem Licht könnte zur Belichtung eines Tauch-Lacks auch die i-, h- oder g- Line des Emissions-Spektrums der Quecksilberlampe genutzt werden.

Nach dem Hard Bake wird der Redox-Katalysator direkt auf Ionen-Austausch-Membran über ein physikalisch-chemisches Abscheideverfahren, das durch die Anwendung eines Plasmas unterstützt wird, in einer Vakuumkammer 472 bzw. 572 aufgebracht.

Diese spezielle Abscheidungs-Technik und der dafür erforderliche Reaktor werden im folgenden Abschnitt beschrieben.

### 2. Gasphasen-Abscheiden 1102 von Nickel (Ni), Cobalt (Co) und Schwefel (S) als HER- Katalysator auf der Ionen-Austausch-Membran.

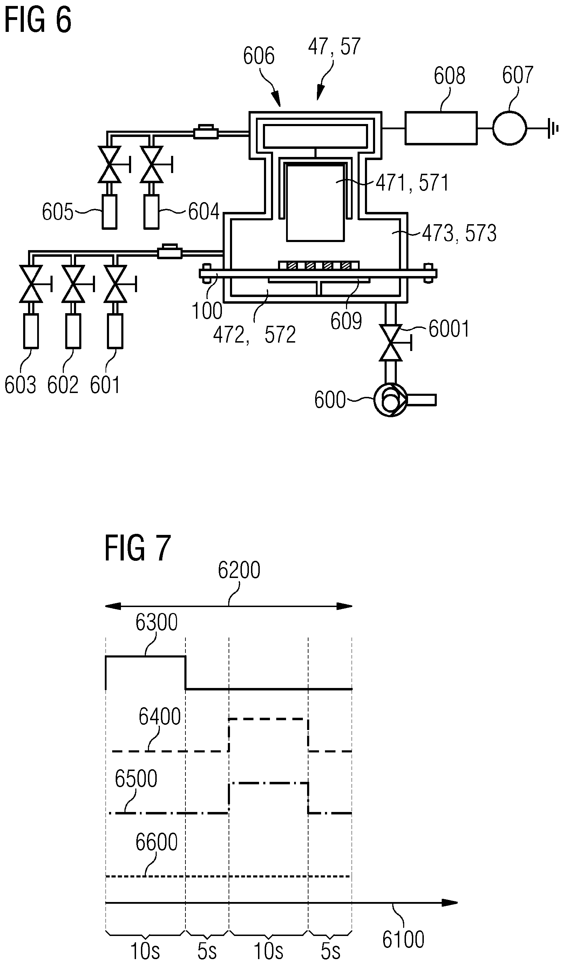

Zum Gasphasen-Abscheiden wird ein physikalisch-chemisches Abscheiden angewendet. Der Abscheideprozess wird in einem Reaktor mit Reaktions-Raum 473 bzw. 573 ausgeführt, wie in Figur 6 schematisch dargestellt ist.

Da die AEM-Folie und die Zirfon^{®}-Folie in alkalisch arbeitenden Elektrolyseuren eingesetzt werden und über diese Folien negativ geladenen Hydroxid- Ionen als Ladungsträger transportiert werden, erfolgt die Einspeisung des Wassers in den Elektrolyseur über die Kathodenseite. Hier beginnt die Spaltung des Wassers in Wasserstoff und Hydroxid- Ionen. Dabei werden die Wasserstoff-Ionen (Protonen) an der Kathode durch Aufnahme von Elektronen sofort entladen und Wasserstoff- Moleküle entstehen.

Aufgrund dieser ersten Reaktion zur Wasserspaltung werden Redox-Katalysatoren ausgewählt, die besonders die Wasserstoff-Bildung im alkalischen Milieu unterstützen (HER-Katalysatoren). Dazu gehören die Metalle aus Nickel- und Cobalt- Gruppe des Periodensystems der Elemente. Eine Kombination aus Nickel und Cobalt mit Schwefel ist hier besonders vorteilhaft. Schwefel dient als Aktivator für Ni Co, in dem Schwefel mit den Metallen Nanokristalle, z.B. Ni₂S₃, bildet, die in einer amorphen Matrix eingebettet sind.

Da die maximale Betriebstemperatur der Zirfon^{®}-Folie 160°C beträgt und die der AEM- Folie 100°C nicht übersteigen sollte, kann die chemische Umsetzung der Nickel- und Cobalt-Precursoren (siehe Tabellen 1 und 2) nicht thermisch durch Erwärmen des Reaktions-Raums und der mit dem Foto-Lack beschichteten Ausgangs-Ionen-Austausch-Membran erfolgen. Die Schichtbildung findet bei Raum-Temperatur über den Einsatz einer Plasmaquelle statt. In dieser Plasmaquelle erhält das schichtbildende Gas über eine Entladung genügend viel Energie, um die an der Zirfon^{®}- oder an der AEM- Oberfläche adsorbierten Nickel- und Cobalt- Precursoren in Ni,Co und S zu überführen.

Die Abscheidung von Ni, Co und S auf Zirfon^{®}-Folie oder auf der AEM-Folie erfolgt in einer Anordnung gemäß Figur 6.

Die AEM-Folie bzw. die Zirfon^{®}-Folie wird im Roll to Roll-Mechanismus in eine Vakuum-Kammer 472 bzw. 572 geschleust und über einer Stütz-Struktur 609 abgelegt. Über eine Turbopumpe 600 wird dabei mit den Ventil 6001 im Reaktion-Raum 473 zw. 573 ein Feinvakuum von ca. 10⁻³ mbar erzeugt.

Der Ni-Precursor 601 und der Co-Precursor 602 werden einerseits in Bubbler (Gasbläschen-Zähler) als Schutz gegen Luftsauerstoff und Luftfeuchtigkeit aufbewahrt und andererseits über Thermostaten in Abhängigkeit von ihrem Dampfdruck erhitzt. Die Bubbler sind mit Zuleitungsrohren und Entnahmerohren ausgestattet. Über die Zuleitungsrohre gelangt Trägergas 603 (Stickstoff) in die Bubbler und vermischt sich dort mit den Metall- Precursor- Dämpfen. Die Stickstoff-Precursor-Dampf- Gemische verlassen über die Entnahmerohre die Bubbler und werden über Rohre pneumatisch mit Hilfe von Ventilen in den Reaktor geleitet. Die Metall- Precursor - Ströme in den Reaktions-Raum hinein werden durch die Dampfdrücke der Meall-Precursoren und den geregelten Durchfluss des N₂- Trägergases so kontrolliert und gesteuert, dass eine Monolage Ni- und Co- Precursor auf die Oberfläche der Ionen-Austausch-Membran chemisorbiert wird.

In einem zweiten Schritt werden überschüssige Ni- und Co-Precursor- Gasmoleküle entfernt und der Reaktor mit Stickstoff gespült.

In einem dritten Schritt wird ein Gemisch aus Schwefelwasserstoff 604 und Argon 605 in eine Plasma-Quelle eingeleitet. Die Plasma-Quelle ist eine Hohlkathoden-Plasma-Quelle 606. Alternativ dazu ist die Plasma-Quelle ein ausreichend starkes elektrisches Wechselfeld zwischen zwei parallelen Platten (kapazitiv gekoppelte Plasma-Quelle) oder eine induktive (magnetische) Leistungs-Einkopplung durch Zylinderspulen oder Planarspulen (induktiv gekoppelte Plasma-Quelle) .

Sowohl in der Hohlkathoden-Plasma-Quelle als auch in der kapazitiv gekoppelten Plasma-Quelle werden zwischen Anode und Kathode hohe Spannung (100 bis 300 Volt) über einen Radiofrequenz-Plasma-Generator 607 erzeugt und dabei auftretende Impedanz- Differenzen (Wechselstromwiderstände) in einer Matching Box 608 minimiert und angepasst.

Bei der induktiv gekoppelten Plasma-Quelle geschieht die Leistung-Einkopplung von Entladungs-Plasmen durch eine extern an den Rezipienten angebrachte Spule. Dabei wird über die Spule, in der Radiofrequenter Strom fließt, ein Wechselfeld erzeugt. Das Wechselfeld dringt durch ein Dielektrikum (Glas oder Keramik), welches eine Einkopplung zulässt, in ein Plasma und induziert dort ein elektrisches Feld. Dieses elektrische Feld treibt einen Strom in dem Plasma.

In den Figuren 4 bis 6 wird eine Hohlkathoden- Plasma-Quelle (wegen niedrigem Plasmapotential und hoher Plasmadichte) gezeigt. Die Schwefelwasserstoff- Moleküle werden bei ca. 10 eV ionisiert. Dabei entstehen negativ geladene HS⁻ - und S²⁻ - Ionen. Diese negativen HS- und Schwefel- Ionen reagieren mit den adsorbierten Ni- und Co- Precursoren auf der Folienoberfläche unter Bildung von NiCoS. Dabei werden die organischen Molekülstrukturen abgespalten und bilden mit dem Wasserstoff aus dem Schwefelwasserstoff- Molekülen volatile organische Moleküle, die leicht zu entfernen sind. In einem vierten Schritt werden die überschüssigen Metall-Precursoren und die abgespaltenen volatilen organischen Restmoleküle entfernt. Dazu werden der Reaktions-Raum und die beschichtete Folie mit Stickstoff gespült.
Die zwei beschriebenen Abscheidungsprozesse und die beiden Spül-/Evakuierungsprozesse zwischen den Schicht- bildenden Schritten umfassen einen Abscheidezyklus, der mehrmals wiederholt wird. Jeder Einzelprozess läuft vollständig ab. Die Metall (Co/ Ni)- Precursoren und das Schwefelwasserstoff/ Argon- Plasma werden sequenziell in die Reaktor-Kammer geleitet und auf die Folienoberfläche solange chemisorbiert, bis die gesamte Oberfläche der Folie belegt ist. Danach finden keine weiteren Adsorptionsvorgänge statt. Die Einwirkdauer der einzelnen Schritte wird so gewählt, dass in einer adäquaten Zeit die gerade eingeleitete Komponente mit der Folienoberfläche reagiert und der überschüssige Dampf, sowie die Nebenprodukte aus dem Reaktions-Raum entfernt werden. Die Adsorptionszeit der Metall- Precursoren, die Spaltungszeit in NiCoS und volatile organische Restmoleküle, sowie die Spülzeiten zwischen den Schicht- bildenden Vorgängen liegen in der Größenordnung von Sekunden. Durch diese Art der Prozessführung begrenzen sich die Oberflächenreaktionen selbst, so dass eine reproduzierbare NiCoS- Schicht mit kalkulierbarer Zusammensetzung abgeschieden wird. Das abgeschiedene Nickel- Cobaltsulfid wächst mit jedem nachfolgenden Zyklus.

Figur 7 zeigt ein mögliches Muster der Taktzeiten für einen Abscheidungszyklus. Gezeigt sind dabei ein Zyklus 6200 mit der Prozess-Zeit 6100 mit dem Verlauf 6300 des Einwirkens von Ni- und von Co-Precursoren, mit dem Verlauf 6400 des Einwirkens einer Mischung aus Schwefelwasserstoff und Argon 6300, Einwirken eines Hochfrequensfeldes und mit dem Verlauf 6500 des Einwirkens eines Hochfrequenzfeldes mit einer Leistung von 100W. Währen des gesamten Zykluses 6200 wird mit Stickstoff gespült (6600).

### 3. Entfernung der Maskierung

Nach Abscheidung des Redox-Katalysators wird die beschichtete Ionen-Austausch-Membran aus dem Reaktor über das Roll to Roll- Prinzip ausgeschleust und die verwendete Fotomaske in der Remover-Einheit 48 bzw. 58 entfernt.

### 4. Precursoren für einen OER- Katalysator an der Anode

Auf der Anodenseite benötigt man wegen der gewünschten Sauerstoff- Erzeugung einen OER-Katalysator. Ein OER-Katalysator ist zum Beispiel NiCoFe für die alkalische Elektrolyse von Wasser. Eine Kombination aus Nickel Cobalt und Eisen oder eine Kombination aus Nickel und Eisen können ebenfalls über Atomlagenabscheidung aus der Gasphase mit Hilfe der entsprechenden Metall- Precursoren auf der anodenseitigen Oberfläche einer Ionen-Austausch-Membran Anionen-Austauschmembran entsprechend dem zuvor beschriebenen Verfahren abgeschieden werden. Mögliche Precursoren für Nickel und Cobalt finden sich in den Tabellen 1 und 3. Eisen-Precursoren sind in Tabelle 3 gelistet.

Für die Abscheidung von Nickel Eisen oder Nickel Cobalt Eisen wird ein Plasma verwendet, das Wasserstoff enthält, z. B.

Formiergas (Gasgemisch aus Stickstoff(N₂) und Wasserstoff (H₂)) .

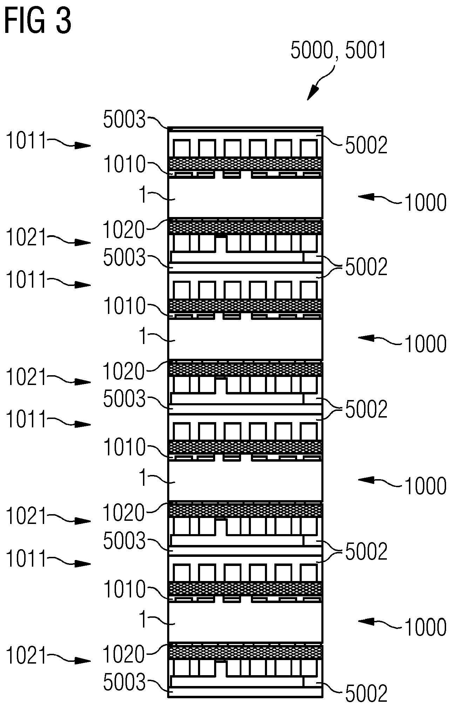

Anwendung findet die Ionen-Austausch-Membran 1 in einer Elektrolyse-Vorrichtung 5000 in Form eines Elektrolyse-Stacks 5001, bei Elektrolyse-Zellen 1000 übereinandergestapelt sind (Figur 3).

Jede der Elektrolyse-Zellen 1000 weist eine Schichtaufbau aus Anode 1010, Ionen-Austausch-Membran 1 und Kathode 1020 auf. Die Elektrolyse-Zellen 1000 der Elektrolyse-Vorrichtung 5000 sind über bipolare Platten 5001 elektrisch und mechanisch miteinander verbunden. Den Abschluss jeder der Elektrolyse-Zellen 1000 bildet eine metallische Endplatte 5003 (z.B. aus Edelstahl).

Die Elektrolyse-Vorrichtung wird zum Herstellen von elementarem Wasserstoff aus Wasser verwendet. Die Elektrolyse-Vorrichtung ist ein Wasser-Elektrolyseur.

## Patentansprüche

1. Ionen-Austausch-Membran (1) für eine Elektrolyse-Zelle (1000) mit
- einer anodenseitigen Membran-Oberfläche (11) zur Begrenzung eines Anoden-Raums (1011) der Elektrolyse-Zelle (1000),
- einer der anodenseitigen Membran-Oberfläche (11) abgewandten kathodenseitigen Membran-Oberfläche (12) zur Begrenzung eines Kathoden-Raums (1021) der Elektrolyse-Zelle (1000) und
- mindestens einer direkt auf mindestens einer der Membran-Oberflächen (11, 12) aufgebrachten Redox-Katalysator-Beschichtung (2) mit Redox-Katalysator-Material (20) wobei
- die Redox-Katalysator-Beschichtung (2) eine Gasphasen-Abscheidung (21) aufweist.

2. Ionen-Austausch-Membran nach Anspruch 1 zum Austauschen von Protonen oder zum Austauschen von Hydroxid-Ionen.

3. Ionen-Austausch-Membran (1) nach Anspruch 1 oder 2, wobei die Redox-Katalysator-Beschichtung (2) mit der Gasphasen-Abscheidung (21) eine durchschnittliche Schichtdicke (22) aufweist, die aus dem Bereich von 1 nm bis 100 nm ausgewählt ist.

4. Ionen-Austausch-Membran (1) nach Anspruch 3, wobei die durchschnittliche Schichtdicke (22) aus dem Bereich von 10 nm bis 90 nm und insbesondere aus dem Bereich von 20 nm bis 80 nm ausgewählt ist.

5. Ionen-Austausch-Membran (1) nach einem der Ansprüche 1 bis 4, wobei die Redox-Katalysator-Beschichtung (2) mit der Gasphasen-Beschichtung (21) eine Beschichtungs-Strukturierung (23) aufweist.

6. Ionen-Austausch-Membran (1) nach Anspruch 5, wobei die Beschichtungs-Strukturierung (23) eine Gitter-Struktur (24) aufweist.

7. Verfahren (1100) zum Herstellen der Ionen-Austausch-Membran (1) nach einem der Ansprüche 1 bis 6, wobei folgende Verfahrensschritte durchgeführt werden:
a) Bereitstellen (1101) einer Ausgangs-Ionen-Austausch-Membran (100) mit einer anodenseitigen Ausgangs-Membran-Oberfläche (101) und einer der anodenseitigen Ausgangs-Membran-Oberfläche (101) abgewandten kathodenseitigen Ausgangs-Membran-Oberfläche (102) und
b) Anordnen (1102) zumindest einer Redox-Katalysator-Beschichtung (2) auf zumindest einer der Ausgangs-Membran-Oberflächen (101, 102), wobei
zum Anordnen der Redox-Katalysator-Beschichtung (2) ein Gas-Phasen-Abscheiden (1102) eines Redox-Katalysator-Materials (20) und/oder eines Ausgangs-Materials (120) des Redox-Katalysator-Materials (20) durchgeführt werden.

8. Verfahren nach Anspruch 7, wobei als Gas-Phasen-Abscheiden ein physikalisches Gasphasen-Abscheiden und/oder ein chemisches Gasphasen-Abscheiden durchgeführt werden.

9. Verfahren nach Anspruch 7 oder 8,
wobei eine Rolle-zu-Rolle-Vorrichtung (70) verwendet wird.

10. Elektrolyse-Vorrichtung (5000) mit zumindest einer Elektrolyse-Zelle (1000) mit Ionen-Austausch-Membran (1) nach einem der Ansprüche 1 bis 6 mit folgendem Schichtaufbau:
- Anode (1010),
- Ionen-Austausch-Membran (1),
- Kathode (1020).

11. Elektrolyse-Vorrichtung (5000) nach Anspruch 10, wobei zumindest zwei Elektrolyse-Zellen (1000) übereinandergestapelt und über mindestens eine bipolare Platte (5001) elektrisch und mechanisch miteinander verbunden sind.

12. Verwendung der Elektrolyse-Vorrichtung (5000) nach Anspruch 10 oder 11 zum Herstellen von elementarem Wasserstoff aus Wasser.
